# FASCICULE DE BREVET EUROPEEN

(11) **EP 3 840 151 B1**
(45) Date de publication et mention de la délivrance du brevet: **26.07.2023**
(21) Numéro de dépôt: 20211754.5
(22) Date de dépôt: 04.12.2020
(51) Int. Cl.: H02G 3/08, H02G 3/10, H02G 3/14

(54) **BOITE ÉLECTRIQUE ET APPAREILLAGE ÉLECTRIQUE ASSOCIÉ**
SCHALTKASTEN UND ZUGEHÖRIGE ELEKTRISCHE AUSRÜSTUNG
ELECTRICAL BOX AND ASSOCIATED ELECTRICAL EQUIPMENT

(30) Priorité: 20.12.2019 FR 1915126
(43) Date de publication de la demande: 23.06.2021
(73) Titulaire: Legrand France, 87000 Limoges (FR); Legrand SNC, 87000 Limoges (FR)
(72) Inventeur: BAUDOU, Alain, 87000 Limoges (FR); JANICOT, Laurent, 87110 Solignac (FR); MALISCHEWSKI, Frédéric, 87700 Beynac (FR)
(74) Mandataire: Jacobacci Coralis Harle

(56) Documents cités:
- EP-A1- 1 860 748
- EP-A1- 2 632 001
- US-B1- 8 053 671

## Description

La présente invention concerne de manière générale le domaine des boîtes électriques isolantes prévues pour loger des mécanismes d'appareillage électrique (typiquement des mécanismes de prise de courant ou de commutateur électrique).

Elle concerne plus particulièrement les boîtes électriques à rapporter en saille sur des parois murales, et notamment les boîtes électrique étanches.

L'invention concerne plus exactement une boîte électrique pourvue d'un corps comprenant, d'une part, une platine-support comportant une paroi de fond pourvue de moyens de fixation à un support de réception et une paroi latérale bordant ladite paroi de fond, et, d'autre part, un cadre comprenant une paroi latérale rapportée dans des moyens de montage de la paroi latérale de ladite platine-support de manière que la paroi latérale du cadre s'étende dans le prolongement de la paroi latérale de la platine-support pour délimiter avec cette dernière un logement ouvert vers l'avant adapté à recevoir un mécanisme d'appareillage électrique.

Le document EP1860748 décrit un appareillage électrique étanche à rapporter en saillie muni d'une boîte électrique du type précité.

On connaît également du document DE50540681 une boîte électrique du type précité, susceptible de recevoir un mécanisme d'appareillage afin de former un appareillage électrique.

Dans cette boîte électrique, les parois latérales de la platine-support et du cadre présentent une hauteur identique égale à 50% de la hauteur totale de la paroi latérale du corps.

Ainsi, ici, la platine-support présente une tenue mécanique satisfaisante mais la hauteur de sa paroi latérale est telle qu'elle gêne l'accès à l'intérieur de ladite platine.

Le but de la présente invention est donc de proposer une boîte électrique en deux parties dans laquelle la platine-support présente une bonne tenue mécanique tout en autorisant une réduction de la hauteur de sa paroi latérale afin de faciliter à un installateur l'accès à l'intérieur de ladite platine.

Plus particulièrement, on propose selon l'invention une boîte électrique conforme à la revendication 1.

Ainsi, avantageusement selon l'invention, la présence d'une paroi double équipée de nervures permet de renforcer mécaniquement la platine-support de la boîte électrique et donc d'augmenter la rigidité globale de cette dernière.

D'autres caractéristiques non limitatives et avantageuses de la boîte électrique conforme à l'invention, prises individuellement ou selon toutes les combinaisons techniquement possibles, sont décrites dans les revendications 2 à 12.

L'invention concerne également un appareillage électrique conforme à la revendication 13.

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique assemblée en perspective d'une boîte électrique conforme à l'invention,
- la figure 2A est une vue schématique en perspective partiellement éclatée de la boîte électrique de la figure 1,
- la figure 2B est une vue schématique assemblée en perspective d'une partie de la boîte électrique conforme à l'invention,
- la figure 3 est une vue schématique partielle en coupe transversale de la platine-support de la boîte électrique de la figure 1, orientée tête en bas,
- la figure 4 est une vue schématique en perspective de l'intérieur d'un coin de la boîte électrique de la figure 1,
- la figure 5 est une vue schématique en perspective arrière de la platine-support de la boîte électrique de la figure 1, et
- la figure 6 une vue schématique en perspective éclatée d'un appareillage électrique comprenant une boîte électrique conforme à l'invention et un enjoliveur.

Dans la description qui va suivre, les termes « avant » et « arrière » seront utilisés par rapport à la direction du regard d'une personne sur l'élément décrit. L'avant de cet élément désigne le côté tourné vers la personne le regardant tandis que l'arrière désigne le côté tourné vers le support sur lequel est rapporté ledit élément.

Les termes « intérieur » (ou « interne ») et « extérieur » (ou « externe ») seront utilisés en référence à la boîte électrique elle-même, pour désigner respectivement le côté d'un élément tourné vers le centre de la boîte électrique et le côté d'un élément tourné vers l'extérieur de cette boîte.

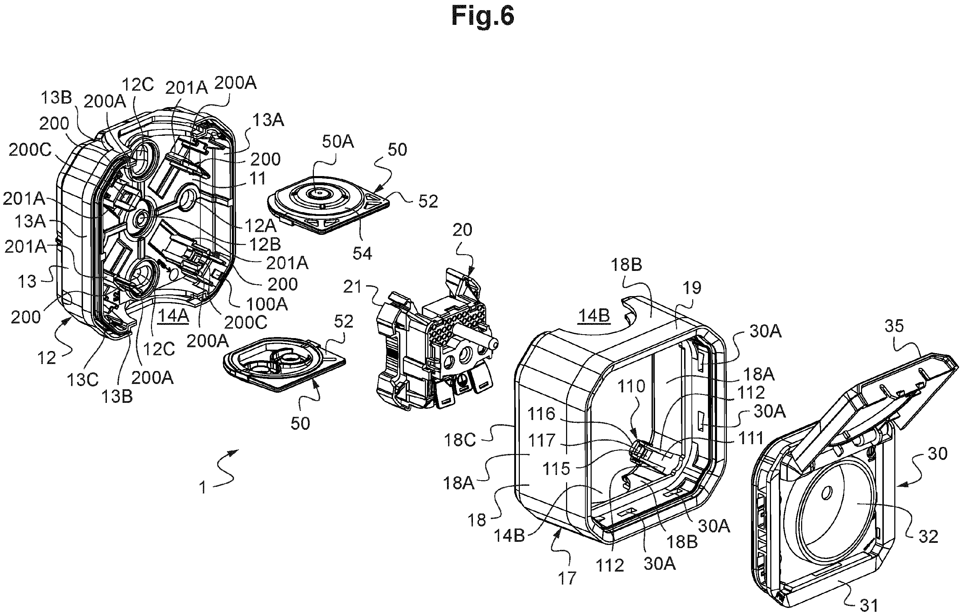

Sur la figure 6, on a représenté un appareillage électrique 1 conforme à l'invention comprenant une boîte électrique 10, un mécanisme d'appareillage électrique 20 reçu dans un logement délimité dans la boîte électrique 10 et un enjoliveur 30 qui ferme l'ouverture avant de la boîte électrique 10 par laquelle on accède à l'intérieur dudit logement et qui confère sa fonction à l'appareillage électrique 1.

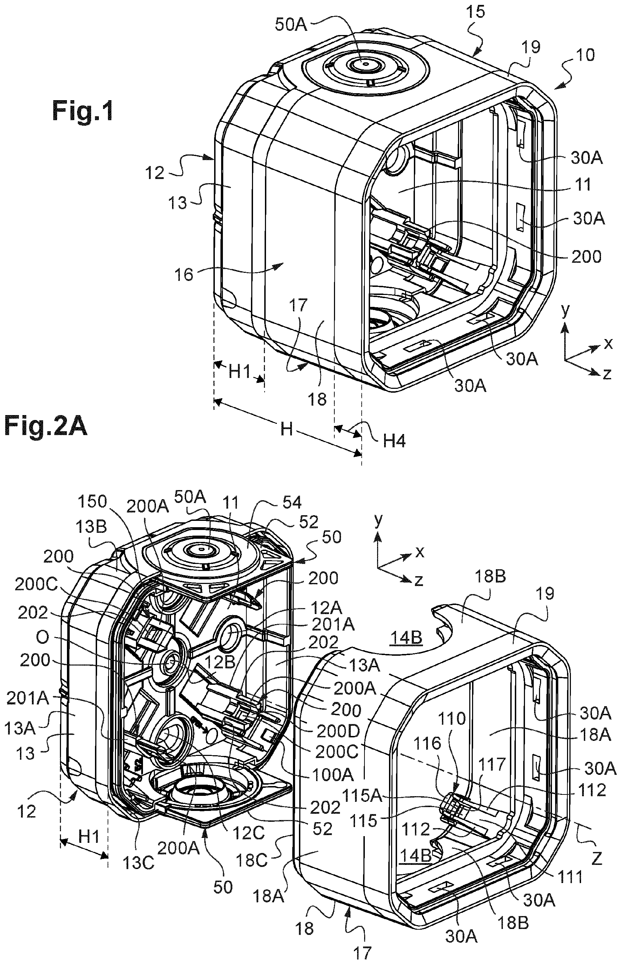

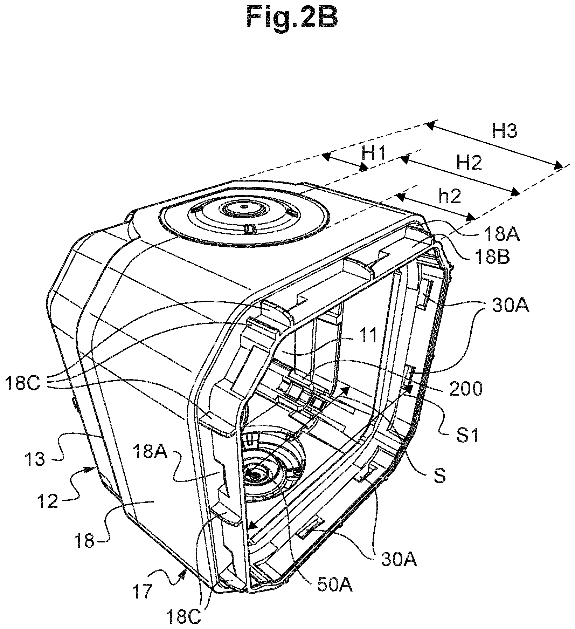

La boîte électrique 10 représentée sur les figures 1, 2A et 2B est une boîte électrique étanche à rapporter en saillie sur une cloison ou paroi murale et agencée pour recevoir intérieurement le mécanisme d'appareillage électrique 20. Ce mécanisme d'appareillage électrique 20 est ici un mécanisme de prise de courant (figure 6) mais il pourrait s'agit de manière similaire d'un mécanisme de commutateur électrique ou d'un mécanisme de détection.

L'enjoliveur 30 présente une forme associée au mécanisme d'appareillage électrique 20. Ici, cet enjoliveur 30 comprend, à l'intérieur d'une partie structurelle 31 en forme de cadre, un puits d'insertion 32 d'une fiche électrique. Cet enjoliveur 30 porte en outre un capot rabattable 35 de protection du puits d'insertion 32.

En variante (non représentée), dans le cas d'un mécanisme de commutateur électrique, l'enjoliveur comporte une ou plusieurs touches de commande adaptées à s'encliqueter sur des moyens de réception prévus sur une paroi qui ferme la partie structurelle en forme de cadre. Ces moyens de réception sont prévus pour offrir à la touche de commande une mobilité en basculement.

Comme le montre la figure 1, la boîte électrique 10 comprend un corps 15 qui présente ici une forme globalement parallélépipédique, mais il pourrait présenter une forme différente, par exemple cylindrique.

Ce corps 15 comprend une paroi latérale 16, de hauteur H3, qui est fermée à l'arrière par une paroi de fond 11. La paroi latérale 16 et la paroi de fond 11 délimitent un logement de réception adapté à recevoir le mécanisme d'appareillage électrique 20. Ce logement de réception est ouvert à l'avant pour permettre l'accès au mécanisme d'appareillage électrique 20 rapporté dans ledit logement.

Comme le montrent les figures 1, 2A et 2B, le corps 15 est en pratique réalisé en deux parties principales distinctes : une partie arrière 12 appelée dans la suite du texte « platine-support 12 » et une partie avant 17 appelée par la suite « cadre 17 ». La platine-support 12 est prévue pour être fixée à la cloison ou paroi murale et supporter le mécanisme d'appareillage électrique 20, tandis que le cadre 17 a une fonction de protection de ce mécanisme d'appareillage électrique 20 et de support de moyens d'interface (en particulier l'enjoliveur 30) permettant à l'utilisateur d'interagir avec le mécanisme d'appareillage électrique 20.

La platine-support 12 est ici réalisée d'une seule pièce en matière plastique moulée, tandis que le cadre 17 est réalisé par le clipsage de deux pièces pour simplifier la réalisation du cadre 17 par moulage.

Comme cela est représenté sur les figures 1, 2A, 2B et 5, la platine-support 12 comprend la paroi de fond 11 bordée par une paroi latérale 13 qui s'élève à partir de la paroi de fond 11, sensiblement perpendiculairement à cette dernière. La paroi latérale 13 de la platine-support 12 suit un contour globalement rectangulaire, en particulier carré, avec des panneaux droits 13A, 13B reliés par des portions en angle formant des coins à angles coupés.

La paroi de fond 11 de la platine-support 12 est pourvue de moyens de fixation à un support de réception, ici la cloison ou paroi murale (non représentée). Ces moyens de fixation à un support de réception sont donc ici bordés par la paroi latérale 13 de la platine-support 11.

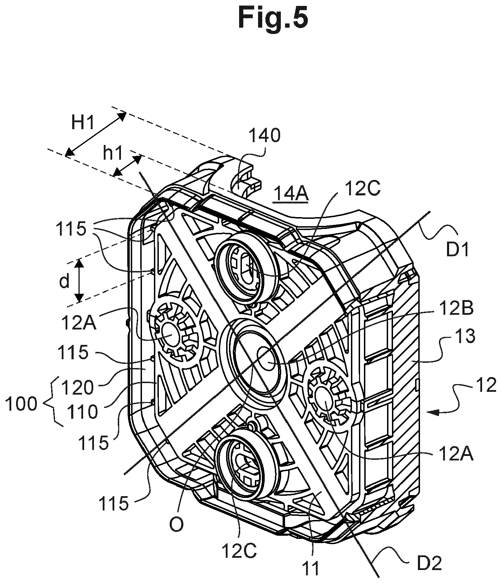

Pour la fixation à un support de réception, la paroi de fond 11 de la platine-support 12 présente des orifices circulaires 12A ici fermés par des opercules d'étanchéité transperçables (figures 2A et 5). Ces orifices circulaires 12A peuvent être traversés par des vis (non représentées) afin de fixer la platine-support 12 sur la cloison ou paroi murale.

Comme le montrent les figures 2A et 5, la paroi de fond 11 de la platine-support 12 présente également des orifices 12C de forme oblongue (dont les axes principaux sont perpendiculaires). Ces orifices 12C de forme oblongue peuvent également être traversés par des vis (non représentées) afin de fixer la platine-support 12 sur la cloison ou paroi murale. La forme oblongue de ces orifices 12C permet d'ajuster l'orientation de montage de la platine-support 12 sur la cloison ou paroi murale.

La paroi de fond 11 de la platine-support 12 comprend également une ouverture centrale 12B, fermée ici par un opercule d'étanchéité déchirable pour le passage par exemple d'un câble électrique (de type U1000R02V ou HO7RNF) ou d'un tube de type IRL ou d'une gaine électrique de type ICTA.

Comme le montrent les figures 1, 2A et 2B, la paroi latérale 13 de la platine-support 12 présente, sur deux panneaux droits 13A opposés, une hauteur maximale H1 déterminée et uniforme. Cette hauteur maximale H1 est par exemple ici comprise entre 20 et 23 millimètres (mm). Lorsque la platine-support 12 et le cadre 17 sont assemblés (comme représenté sur la figure 1), la hauteur maximale H1 est de l'ordre de 20 mm.

Sur les deux autres panneaux droits 13B opposés de la paroi latérale 13 de la platine-support 12, la hauteur de cette paroi latérale 13 diminue localement, depuis la hauteur maximale H1, jusqu'à une hauteur minimale h1 (figure 5). Cette hauteur minimale h1 est par exemple inférieure ou égale à 10% de la hauteur totale maximale H3 de la paroi latérale 16 du corps 15 (figures 2B et 5).

Comme le montre plus particulièrement la figure 5, cette diminution locale de la hauteur, depuis la hauteur maximale H1 vers la hauteur minimale h1, forme une première partie 14A d'ouverture d'entrée à l'intérieur du corps 15 de la boîte électrique 10 dans chaque panneau droit 13B correspondant de la paroi latérale 13 de la platine-support 12. Ici, deux premières parties 14A d'ouvertures d'entrée sont donc formées sur les panneaux droits 13B opposés correspondants de la paroi latérale 13 de la platine-support 12.

Comme le montrent également les figures 2A à 4, un bord avant 13C périphérique de la paroi latérale 13 de la platine-support 12 présente une forme particulière qui délimite une gorge 140 ouverte vers l'avant. Cette gorge 140 s'étend le long du bord avant 13C de cette paroi latérale 13, y compris le long des premières parties 14A d'ouvertures formées dans les panneaux droits 13B opposés de la paroi latérale 13 de la platine-support 12 (voir figure 5).

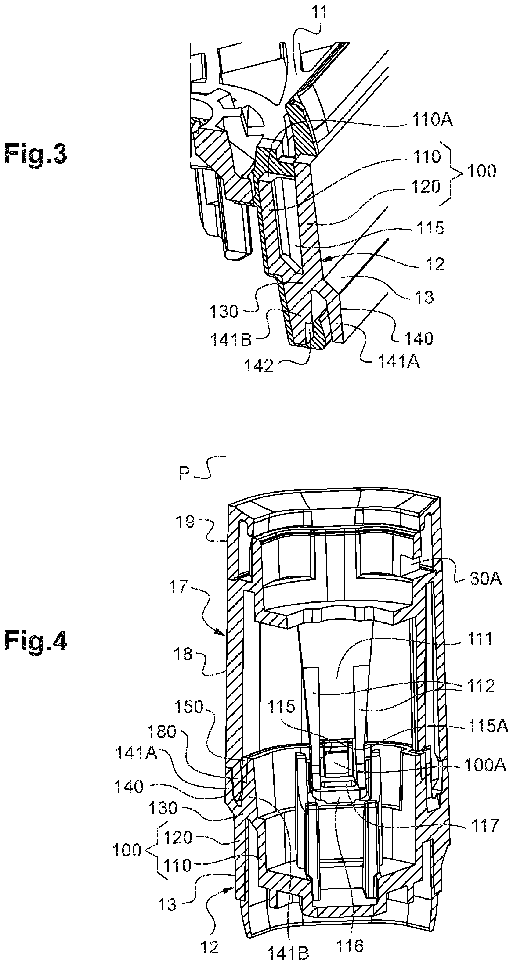

En dehors de la partie qui longe chaque première partie 14A d'ouverture d'entrée, il est prévu dans la gorge 140, un joint d'étanchéité 150 (figure 4) positionné entre le bord avant 13C de la paroi latérale 13 de la platine-support 12 et un bord arrière 18C périphérique d'une paroi latérale 18 du cadre 17. Le joint d'étanchéité 150 assure un assemblage étanche entre la platine-support 12 et le cadre 17.

Comme le montrent les figures 1 et 2A, la partie de la gorge 140 s'étendant le long de chaque première partie 14A d'ouverture d'entrée est destinée à recevoir, par coulissement, un embout passe-câble 50.

Ici, deux embouts passe-câble 50 sont montés sur la platine-support 12, dans les deux premières parties 14A d'ouverture d'entrée formées sur les panneaux droits 13B opposés correspondants de la paroi latérale 13 de la platine-support 12.

Comme le montre la figure 2A, chaque embout passe-câble 50 comporte une plaquette support 52 munie d'un bord périphérique intérieur qui délimite une ouverture 50A pour le passage d'un câble électrique ou d'un tube de type IRL ou d'une gaine électrique de type ICTA. Chaque embout passe-câble 50 comprend également une membrane d'étanchéité 54 souple et perforable, surmoulée au moins partiellement sur la plaquette support 52, qui obture ladite ouverture 50A et qui est adaptée à être traversée par le câble électrique ou le tube de type IRL ou la gaine électrique de type ICTA. Ainsi, c'est une partie de la plaquette support 52 de chaque embout passe-câble 50 qui est coulissée dans la gorge 140 de la première partie 14A d'ouverture d'entrée formée dans le panneau droit 13B correspondant de la paroi latérale 13 de la platine-support 12.

Pour permettre le montage du mécanisme d'appareillage électrique 20 dans la boîte électrique 10, la paroi de fond 11 de la platine-support 12 porte des montants 200 (figures 2A et 2B). Ces montants 200 s'étendent vers l'avant à partir de la paroi de fond 11. Ils s'étendent perpendiculairement à celle-ci.

Les montants 200 sont formés d'une seule pièce, en matière plastique moulée, avec la platine-support 12.

Comme le montre la figure 2A, il est ici prévu quatre montants 200 disposés, par paire, de manière symétrique par rapport à un centre O de la paroi de fond 11 de la platine-support 12.

Le centre O de la paroi de fond 11 de la platine-support 12 est donc un centre de symétrie pour le positionnement des montants 200. Cette symétrie centrale dans le positionnement des montants 200 de la platine-support 12 permet d'autoriser le montage du mécanisme d'appareillage électrique 20 dans la boîte électrique 10 dans différentes positions décalées l'une par rapport à l'autre par rotation autour d'un axe Z (figure 2A) orthogonal à la paroi de fond 11 de la platine-support 12 et passant par le centre O de cette paroi de fond 11.

Ici, les montants 200 de la platine-support 12 sont disposés dans des zones situées en regard des portions en angle formant les coins de la paroi latérale 13 de la platine-support 12, de manière orthogonale aux diagonales D1, D2 de la paroi de fond 11 (figure 5).

Comme cela est représenté sur la figure 2A, chaque montant 200 présente ici une partie avant 200A et une partie arrière 201A.

Chaque partie arrière 201A est attachée à la paroi de fond 11 de la platine-support 12. Elle présente globalement un contour rectangulaire avec une forme légèrement incurvée convexe vers l'extérieur. Les bords latéraux de chaque partie arrière 201A forment des nervures.

Comme le montre également la figure 2A, la partie avant 200A de chaque montant 200 s'étend vers l'avant à partir de la partie arrière 201A.

La partie avant 200A présente une forme de U renversé définie par deux branches latérales 200B et une branche 200D parallèle à la paroi de fond 11 de la platine-support 12 et joignant les deux branches latérales 200B à leur extrémité éloignée de la partie arrière 201A (cette branche 200D correspond à la base du U renversé). Les branches latérales 200B forment également des nervures. Les nervures des branches latérales 200B permettent ici le coulissement des moyens de montage du socle du mécanisme d'appareillage électrique 20 lors du montage de ce dernier dans la boîte électrique 10.

L'ensemble des branches latérales 200B, de la branche 200D et de la partie supérieure de la partie arrière 201A délimite une fenêtre 200C dans chaque montant 200.

Comme le montrent également la figure 2A, la partie avant 200A présente une épaisseur plus faible que la partie arrière 201A, formant alors un décroché 202. Ce décroché 202 permet la formation d'un rebord de butée 202 qui s'étend entre les parties avant 200A et arrière 201A de chaque montant 200. Ce rebord de butée 202 formé permet alors, lors du montage du mécanisme d'appareillage électrique 20 dans la boîte électrique, de positionner le socle du mécanisme d'appareillage électrique 20 dans la boîte électrique 10 à une distance déterminée de la paroi de fond 11 de la platine-support 12 de manière à laisser un espace libre pour placer aisément les fils de raccordement électrique.

L'agencement des nervures des branches latérales 200B et de la fenêtre 200C de la partie avant 200A de chaque montant 200, combiné avec le rebord de butée 202 formé à la jonction des parties avant et arrière 200A, 201A de chaque montant 200, constitue un moyen de montage par encliquetage du socle du mécanisme d'appareillage. Le socle du mécanisme d'appareillage comporte alors, à ses quatre coins, quatre moyens d'encliquetage identiques (non représentés) adaptés à coopérer avec les moyens de montage par encliquetage, décrits précédemment, des quatre montants 200.

Ici, la hauteur maximale H1 de la paroi latérale 13 de la platine-support 12 est inférieure ou égale à 50% de la hauteur totale maximale H3 de la paroi latérale 16 du corps 15. De préférence, cette hauteur maximale H1 de la paroi latérale 13 de la platine-support 12 est inférieure ou égale à 40% de la hauteur totale maximale H3 de la paroi latérale 16 du corps 15. De préférence encore, cette hauteur maximale H1 de la paroi latérale 13 de la platine-support 12 est strictement inférieure à 40% de la hauteur totale maximale H3 de la paroi latérale 16 du corps 15. Dans l'exemple représenté sur les figures 1 à 2B, cette proportion est de l'ordre de 37%. Ainsi, comme la hauteur de la paroi latérale 13 de la platine-support 12 est plus faible, l'accès à l'intérieur de la platine-support 12, par exemple pour un installateur lors du raccordement électrique, est facilité.

Plus généralement, de manière avantageuse, la hauteur maximale H1 de la paroi latérale 13 de la platine-support 12 est déterminée de manière à ce qu'une partie du bord avant 13C de la paroi latérale 13 de la platine-support 12, qui longe le bord arrière 18C de la paroi latérale 18 du cadre 17, est située à une hauteur déterminée, ici la hauteur maximale H1, par rapport à la paroi de fond 11, en retrait d'une distance minimum par rapport aux ouvertures d'accès (non représentées) à des bornes de connexion électrique du mécanisme d'appareillage électrique 20 rapporté sur les montants 200 de ladite platine-support 12. Par retrait, on entend ici un retrait en hauteur, c'est-à-dire que la hauteur de la paroi latérale 13 de la platine-support 12 est en partie inférieure à la hauteur à laquelle sont positionnées les ouvertures d'accès (non représentées) aux bornes de connexion électrique du mécanisme d'appareillage électrique 20.

De manière avantageuse, afin de garantir une bonne tenue mécanique et la rigidité de la platine-support 12 malgré la faible hauteur de sa paroi latérale 13, la paroi latérale 13 de la platine-support 12 comporte une paroi double 100.

Comme le montrent les figures 3 et 4, la paroi double 100 est formée sur une partie arrière de la paroi latérale 13 de la platine-support 12. Ainsi, la paroi double 100 est formée à l'arrière des moyens de montage du cadre 17 sur la paroi latérale 13 de la platine-support 12.

Comme le montrent également les figures 3 et 4, la paroi double 100 comprend une paroi interne 110 et une paroi externe 120, placées en regard l'une de l'autre. Cette paroi double 100 s'étend sur au moins une partie du pourtour de la paroi latérale 13 de la platine-support 12. La paroi double 100 s'étend ici le long de tout le pourtour de la paroi latérale 13 de la platine-support 12 en dehors de chaque portion de la paroi latérale 13 longeant chaque première partie 14A d'ouverture d'entrée.

En variante, la paroi double pourrait s'étendre sur l'ensemble du pourtour de la paroi latérale 13 de la platine-support 12, y compris le long de chaque portion de la paroi latérale 13 longeant chaque première partie 14A d'ouverture d'entrée.

De manière avantageuse, la paroi interne 110 et la paroi externe 120 sont reliées par des nervures 115 (figures 3 et 5). Ces nervures 115 forment des entretoises de renfort entre la paroi interne 110 et la paroi externe 120 et confèrent ainsi une plus grande résistance mécanique à la paroi latérale 13 de la platine-support 12.

Comme le montre la figure 5, ces nervures 115 sont localisées à des endroits ponctuels de la paroi double 100. Elles sont régulièrement réparties le long de la paroi double 100. Par exemple, comme le montre la figure 5, le long de chaque portion de la paroi double 100 logée dans chaque panneau droit 13A de la paroi latérale 13 de la platine-support 12, les nervures sont espacées deux à deux d'une distance d prédéterminée. Comme le montre également la figure 5, les nervures 115 sont aussi ici localisées dans les portions en angle de la paroi latérale 13 de la platine-support 12.

Comme cela est représenté sur la figure 3, chaque nervure 115 s'étend en largeur, perpendiculairement aux faces en regard de la paroi interne 110 et de la paroi externe 120 de la paroi double 100.

Selon une variante non représentée, chaque nervure pourrait s'étendre, en largeur, selon une direction formant un premier angle aigu, c'est-à-dire inférieur à 90 degrés, avec la face de la paroi interne tournée vers la paroi externe de la paroi double.

Selon une autre variante non représentée, chaque nervure pourrait s'étendre, en largeur, selon une direction formant un deuxième angle aigu (inférieur à 90 degrés), avec la face de la paroi externe tournée vers la paroi interne de la paroi double.

Selon une autre variante encore non représentée, le premier angle et le deuxième angle sont égaux, signifiant alors que la paroi interne et la paroi externe sont globalement parallèles au niveau des nervures.

Comme le montre la figure 3, chaque nervure 115 s'étend, en hauteur, sur toute la hauteur de la paroi double 100. Plus précisément ici, comme cela est visible sur la figure 3, sachant que la paroi externe 120 de la paroi double 100 présente une hauteur supérieure à la paroi interne 110 de la paroi double 100, la paroi double 100 s'étend, en hauteur, jusqu'à une région située à proximité d'un bord arrière libre 110A de la paroi interne 110. Chaque nervure 115 s'étend donc, en hauteur, jusqu'à la région située à proximité de ce bord arrière libre 110A de la paroi interne 110.

Afin de renforcer encore la tenue mécanique de la platine-support 12, la paroi interne 110 de la paroi double 100 et la paroi externe 120 de la paroi double 100 sont reliées entre elles par un pont 130 de matière. Ce pont 130 de matière s'étend sur l'ensemble du pourtour de la paroi double 100. Il est formé d'une seule pièce avec la paroi double 100, donc avec la platine-support 12, par exemple en matière plastique moulée.

Comme le montre la figure 3, chaque nervure 115 s'étend alors depuis la région située à proximité du bord libre 110A de la paroi interne 110 de la paroi double 100 jusqu'au pont 130.

L'ensemble formé par les nervures 115 et le pont 130 permet de conférer à la platine-support 12 de la boîte électrique 10 une tenue mécanique très satisfaisante. Cette tenue mécanique permet à la platine-support 12 de résister notamment aux efforts de vissage exercés sur elle lors de sa fixation à une cloison ou paroi murale et aux efforts d'assemblage de la paroi latérale 18 du cadre 17 sur la paroi latérale 13 de ladite platine-support 12. Ainsi, la rigidité globale de la boîte électrique 10 est ainsi augmentée, plus particulièrement lors de l'assemblage du cadre 17 sur la platine-support 12 décrit ultérieurement.

Dans le but de permettre cet assemblage du cadre 17 sur la platine-support 12, la paroi latérale 13 de la platine-support 12 comprend, sur une partie avant, les moyens de montage du cadre 17. Ici, les moyens de montage du cadre 17 comprennent la gorge 140 ouverte vers l'avant, formée dans le bord avant 13C périphérique de la paroi latérale 13 de la platine-support 12.

Comme le montrent les figures 3 et 4, cette gorge 140 présente globalement une forme de U définie par deux murets périphériques 141A, 141B en regard reliés entre eux par le pont 130.

Comme le montrent également les figures 3 et 4, l'un des murets périphériques 141B comprend, sur sa face tournée vers l'autre muret 141A, un décroché 142 qui jouxte son extrémité libre. Ce décroché 142 est destiné à recevoir le joint d'étanchéité 150 (figure 4) décrit précédemment et permettant un assemblage étanche entre le cadre 17 et la platine-support 12.

Comme le montre plus particulièrement la figure 4, la gorge 140 est adaptée à recevoir une nervure 180 périphérique formant le bord arrière 18C de la paroi latérale 18 du cadre 17. Cette nervure 180 présente une forme adaptée à s'emboîter dans la gorge 140 de la paroi latérale 13 de la platine-support 12.

La gorge 140 de la paroi latérale 13 de la platine-support 12 et la nervure 180 périphérique de la paroi latérale 18 du cadre 17 forment des moyens d'emboîtement entre ladite paroi latérale 18 du cadre 17 et ladite paroi latérale 13 de la platine-support 12. Comme le montre la figure 4, ces moyens d'emboîtement sont tels qu'à la jonction entre le cadre 17 et la platine-support 12, la face externe de la paroi latérale 18 du cadre 17 s'étend dans un même plan P (figure 4) que la face externe de la paroi latérale 13 de la platine-support 12. Les flancs du corps 15 de la boîte électrique 10 sont alors rectilignes, sans déformations.

Lorsque la nervure 180 périphérique de la paroi latérale 18 du cadre 17 est emboîtée dans la gorge 140 de la paroi latérale 13 de la platine-support 12, elle comprime le joint 150 qui réalise l'étanchéité entre les deux parois latérales 13, 18 (et donc entre la platine-support 12 et le cadre 17).

En variante, les moyens de montage du cadre pourraient être formés par une nervure s'étendant du bord libre avant de la paroi latérale de la platine-support, à partir du pont reliant les parois interne et externe de la paroi double. Dans ce cas, l'extrémité libre du bord arrière du cadre serait formée d'une gorge adaptée à accueillir cette nervure. Ces deux moyens de coopération permettraient ici aussi d'assurer un alignement des faces externes des parois latérales du cadre et de la platine-support.

Par ailleurs, comme le montrent les figures 2A, 2B et 6, la paroi latérale 18 du cadre 17 se présente sous la forme d'un manchon présentant une ouverture centrale d'une section S donnée. Cette paroi latérale 18 du cadre 17 est prévue pour être rapportée sur la paroi latérale 13 de la platine-support 12 pour s'étendre dans le prolongement de celle-ci de manière à former la paroi latérale 16 du corps 15. Plus particulièrement, la paroi latérale 18 du cadre 17 est prévue pour être rapportée dans les moyens de montage prévus dans la paroi latérale 13 de la platine-support 12. De plus, la majeure partie de la paroi latérale 18 du cadre 17 vient dans le prolongement de la paroi latérale 13 de la platine-support 12. La paroi latérale 18 du cadre 17 suit un contour globalement rectangulaire, en particulier carré, avec des panneaux droits 18A, 18B reliés par des portions en angle formant des coins à angles coupés, en correspondance avec le contour de la paroi latérale 13 de la platine-support 12.

Comme le montre la figure 2B, à l'avant, la paroi latérale 18 du cadre 17 décroche de manière à former un trottoir 18A, s'étendant perpendiculairement à la majeure partie de la paroi latérale 18 du cadre 17.

La partie avant 18B de la paroi latérale 18 du cadre 17 s'étend de manière concentrique à la majeure partie de la paroi latérale 18 du cadre 17. Cette partie avant 18B délimite une section réduite S1 de l'ouverture centrale (figure 2B). Le décroché de la paroi latérale 18 du cadre 17 permet alors de réduire à l'avant la section de cette ouverture centrale.

Le décroché de la paroi latérale 18 de cadre 17 est conformé pour recevoir une rehausse 19 en forme de cadre de plus faible hauteur H4 (figures 1, 2A et 6). La hauteur H4 est par exemple ici de l'ordre de 10,4 mm. Cette rehausse est fixée sur le cadre 17 par clipsage. Pour cela, la rehausse comporte quatre clips disposés aux quatre coins de cette rehausse, qui viennent se loger dans des logements de forme correspondante prévus aux quatre coins du cadre 17. En outre, comme le montre la figure 2B, la partie avant 18B de la paroi latérale 18 du cadre 17 comprend, le long de son pourtour, des nervures 18C de centrage de la rehausse 19. La rehausse 19 est donc destinée à être rapportée sur ces nervures 18C sur une partie extérieure de la partie avant 18B de la paroi latérale 18 du cadre 17 et fixée par clipsage au cadre 17. Ainsi, le cadre 17 est réalisé par l'association par clipsage du manchon formé par la paroi latérale 18 et de la rehausse 19. L'utilisation de deux sous-parties pour la réalisation du cadre 17 permet d'en simplifier la conception par moulage. La rehausse 19 a un rôle esthétique et est conçue pour occulter la partie avant du cadre 17.

En variante, le cadre pourrait être réalisé d'une seule pièce, par exemple en matière plastique moulée.

Comme le montrent les figures 1, 2A et 6, le cadre 17 est conçu, sur le décroché formé par la partie avant de la paroi latérale 18 du cadre 17, pour recevoir l'enjoliveur 30. Pour cela, le cadre 17 comprend, sur la partie avant 18B de la paroi latérale 18 du cadre 17, des orifices 30A de fixation de l'enjoliveur 30. Ces orifices 30A sont adaptés à recevoir des éléments permettant le montage de l'enjoliveur 30 sur le cadre 17. Ces éléments (non visibles) de montage sont par exemple des éléments quart-de-tour, manoeuvrables depuis la face avant de l'enjoliveur 30.

De manière similaire à la paroi latérale 13 de la platine-support 12, comme le montre la figure 2A, la paroi latérale 18 du cadre 17 présente, sur deux panneaux droits 18A opposés s'étendant dans le prolongement des panneaux droits 13A opposés de la paroi latérale 13 de la platine-support 12, une hauteur maximale H2 déterminée et uniforme (figure 2B).

Sur les deux autres panneaux droits 18B opposés, s'étendant eux dans le prolongement des panneaux droits 13B opposés de la paroi latérale 13 de la platine-support 12, la hauteur de cette paroi latérale 18 diminue localement, depuis la hauteur maximale H2, jusqu'à une hauteur minimale h2 (figure 2B). Cette hauteur minimale h2 est par exemple inférieure ou égale à 20% de la hauteur totale maximale H3 de la paroi latérale 16 du corps 15. Cette diminution locale de hauteur dans la paroi latérale 18 forme une deuxième partie 14B d'ouverture d'entrée. Ici, deux deuxièmes parties 14B d'ouverture d'entrée sont formées sur les panneaux droits 18B opposés de la paroi latérale 18 du cadre 17. Chaque deuxième partie 14B d'ouverture d'entrée est destinée à venir en correspondance avec l'une des premières parties 14A d'ouverture d'entrée formée sur l'un des autres panneaux droits 13B opposés de la paroi latérale 13 de la platine-support 12.

Ainsi, la combinaison d'une première partie 14A d'ouverture d'entrée de la paroi latérale 13 de la platine-support 12 avec une deuxième partie 14B d'ouverture d'entrée de la paroi latérale 18 du cadre 17, lors de l'assemblage de la platine-support 12 et du cadre 17 décrit ci-après, forme une ouverture d'entrée complète. Ici, comme le montrent la figure 2A, deux ouvertures d'entrée complètes sont formées sur deux panneaux opposés de la paroi latérale 16 du corps 15. En variante, les ouvertures d'entrée pourraient être formées sur deux panneaux adjacents de la paroi latérale du corps.

De manière similaire à la paroi latérale 13 de la platine-support 12, le bord arrière 18C périphérique de la paroi latérale 18 du cadre 17 présente, le long de chaque deuxième partie 14B d'ouverture d'entrée formée dans chaque panneau droit 18B correspondant, une forme particulière qui délimite une gorge ouverte vers l'arrière. Cette gorge est également destinée à recevoir, par coulissement, un embout passe-câble 50, et plus précisément une partie de la plaquette support 52 de celui-ci.

En dehors de la partie qui longe chaque deuxième partie 14B d'ouverture d'entrée, le bord arrière 18C de la paroi latérale 18 du cadre 17 présente la nervure 180 périphérique adaptée à s'insérer ou à s'emboîter dans la gorge 140 formée le long du bord avant 13C de la paroi latérale 13 de la platine-support 12, lors de l'assemblage de la platine-support 12 et du cadre 17.

Le joint d'étanchéité 150 décrit précédemment et permettant d'établir une jonction étanche entre le bord avant 13C périphérique de la paroi latérale 13 de la platine-support 12 et le bord arrière 18C périphérique de la paroi latérale 18 du cadre 17 est donc positionné entre les faces de ladite gorge 140 et de ladite nervure 180 (figure 4).

L'emboîtement de la nervure du cadre 17 dans la gorge 140 de la platine-support 12 assure un blocage relatif du cadre 17 par rapport à la platine-support 12 dans un plan (x, y) parallèle au plan de la cloison ou paroi murale. En revanche, cet emboîtement ne permet pas de bloquer le cadre 17 par rapport à la platine-support 12 selon un axe z orthogonal au plan de ladite cloison ou paroi murale.

Pour assurer ce blocage, la platine-support 12 et le cadre 17 comprennent des moyens d'attache complémentaires destinés à verrouiller l'assemblage du cadre 17 sur la platine-support 12. Ces moyens d'attache complémentaires sont ici des moyens d'encliquetage déverrouillables.

Il est prévu ici quatre jeux de moyens d'attache complémentaires respectivement situés aux quatre coins de la boîte électrique 10. Cela permet d'assurer une fixation robuste du cadre 17 sur la platine-support 12 tout en libérant de l'espace à l'intérieur de la boîte électrique 10 pour permettre un agencement optimisé des câbles électriques.

Comme le montrent les figures 2A et 4, chaque moyen d'attache prévu sur la platine-support 12 se présente sous la forme d'un cran 100A formé d'une seule pièce avec la platine-support 12, ici par moulage d'une matière plastique.

Chaque cran 100A s'étend en saillie de la face intérieure de chaque portion en angle de la paroi latérale 13 de la platine-support 12 et présente un profil pointu tourné vers l'intérieur.

Comme le montrent les figures 2A et 4, chaque moyen d'attache prévu sur le cadre 17 et destiné à coopérer avec chaque cran 100A de la platine-support 12 est porté par un levier. Chaque levier est formé d'une seule pièce avec la paroi latérale 18 du cadre 17 et s'étend en saillie de la face intérieure de chaque portion en angle de cette paroi latérale 18.

Comme le montrent les figures 2A et 4, chaque levier se présente sous la forme d'une plaquette rectangulaire 111 bordée de deux flancs de rigidification 112.

Chaque levier est rattaché à la paroi latérale 18 du cadre 17 uniquement par son extrémité avant. Il est élastiquement déformable au niveau de sa jonction avec la paroi latérale 18 du cadre 17, qui forme alors une charnière.

Comme le montrent les figures 2A et 4, chaque levier présente une ouverture 115 adaptée à s'engager sur le cran 100A correspondant de la platine-support 12. Cette ouverture 115 présente notamment un bord 115A (figures 2A et 4) adapté à s'accrocher sur une face arrière du cran 100A de manière à verrouiller le cadre 17 sur la platine-support 12.

L'extrémité arrière de chaque levier est recourbée vers l'intérieur du cadre 17 de façon à former un rebord 116. Ce rebord 116 comprend une fente 117 dans laquelle l'extrémité d'un outil tel qu'un tournevis peut être introduite, par exemple pour désengager le cran 100A du levier afin de libérer le levier (et donc détacher le moyen d'attache du cadre 17 de celui de la platine-support 12).

On notera que lorsque le cadre 17 muni de sa rehausse 19 est emboîté sur la platine-support 12, la boîte électrique 10 présente une paroi latérale de hauteur totale H (figure 1). Cette hauteur totale H est par exemple comprise entre 54 et 57 mm. De préférence ici, lorsque la platine-support 12, le cadre 17 et la rehausse 19 sont assemblés comme représenté sur la figure 1, la hauteur totale H est de l'ordre de 54 mm.

Lors du montage de l'appareillage électrique 1 en saillie sur une cloison murale, l'installeur fixe d'abord la platine-support 12 sur le mur en introduisant des vis dans les orifices 12C de forme oblongue et en ajustant cette fixation en rotation avant d'introduire des vis dans les orifices circulaires 12A (figure 2A).

Ensuite, l'installateur introduit un câble électrique ou un tube ou une gaine électrique au travers de la membrane d'étanchéité 54 d'un embout passe-câble 50.

Selon une première alternative de montage, l'installateur insère la plaquette-support 52 de cet embout passe-câble 50 dans la gorge formée dans la paroi latérale 13 de la platine-support 12, le long d'une première partie 14A d'ouverture d'entrée.

L'installateur positionne ensuite le mécanisme d'appareillage électrique 20 sur les montants 200 de la platine-support 12. Comme le montre la figure 2A, l'embout-passe-câble 50, lorsqu'il est introduit dans la paroi latérale 13 de la platine-support 12, présente une hauteur supérieure à celle de la paroi latérale 13 de la platine-support 12 et pourrait gêner le raccordement électrique du mécanisme d'appareillage électrique 20 (c'est-à-dire l'insertion de chaque fil de raccordement électrique dans chaque borne électrique, via chaque ouverture d'accès correspondante du mécanisme d'appareillage électrique 20). Mais, de manière avantageuse ici, l'installateur tire profit, d'une part, de la faible hauteur de la paroi latérale 13 de la platine-support 12 (en dehors des embouts passe-câble) afin d'accéder à l'intérieur de la platine-support 12, et, d'autre part, que les ouvertures d'accès aux bornes électriques du socle du mécanisme d'appareillage électrique 20 rapporté sur les montants 200 de la platine-support 12, soient positionnées en retrait en hauteur (donc au-dessus) de cette paroi latérale 13 pour réaliser très aisément ce raccordement électrique.

Comme les moyens de butée présents sur les montants 200 permettent de positionner le socle du mécanisme d'appareillage 20 à distance de la paroi de fond 11 de la platine-support 12, l'installateur peut agencer les fils de raccordement électrique afin qu'ils ne soient pas pincés et de limiter l'encombrement dans la boîte électrique 10.

Selon une deuxième alternative de montage, une fois le câble électrique ou le tube ou la gaine électrique introduit dans l'embout passe-câble 50, l'installateur raccorde électriquement le mécanisme d'appareillage électrique 20. Puis il insère la plaquette-support 52 de cet embout passe-câble 50 dans la gorge formée dans la paroi latérale 13 de la platine-support 12, le long d'une première partie 14A d'ouverture d'entrée tout en positionnant le mécanisme d'appareillage électrique 20 sur les montants 200 de la platine-support 12. L'installateur tire également profit ici de la faible hauteur de la paroi latérale 13 de la platine-support 12 et de la distance entre le socle du mécanisme d'appareillage électrique 20 et la paroi de fond 11 de la platine-support 12 pour agencer les fils de raccordement électrique.

Une fois le mécanisme d'appareillage électrique 20 monté et raccordé électriquement, l'installateur assemble, sur la platine-support 12, le cadre 17 muni de sa rehausse 19, par emboîtement grâce aux moyens de coopération entre la paroi latérale 18 du cadre 17 et la paroi latérale 13 de la platine-support 12 et par encliquetage grâce aux moyens d'attache complémentaires. Le cadre 17 permet une protection mécanique et électrique du mécanisme d'appareillage électrique 20 ainsi que des fils de raccordement électrique logés à l'intérieur de la boîte électrique 10. Enfin, l'installateur monte l'enjoliveur 30 dans les orifices 30A de la partie avant 18B de la paroi latérale 18 du cadre 17 afin de fermer hermétiquement l'ouverture avant de la boîte électrique 10 et de donner sa fonction à l'appareillage électrique 1.

Sur les différentes figures, la boîte électrique présente une section de forme carrée et elle définit un unique poste permettant d'accueillir un ou deux mécanismes d'appareillage électrique : on dit qu'il s'agit d'une boîte monoposte.

En variante, il pourrait s'agir d'une boîte multiposte, présentant une section de forme rectangulaire et définissant deux ou trois postes. Dans cette variante, la boîte électrique comportera de préférence un cadre définissant plusieurs ouvertures, chacune étant destinée à recevoir un poste.

## Revendications

1. Boîte électrique (10) pourvue d'un corps (15) comprenant, d'une part, une platine-support (12) comportant une paroi de fond (11) pourvue de moyens de fixation à un support de réception et une paroi latérale (13) bordant ladite paroi de fond (11), et, d'autre part, un cadre (17) comprenant une paroi latérale (18) rapportée dans des moyens de montage de la paroi latérale (13) de ladite platine-support (12) de manière que la paroi latérale (18) du cadre (17) s'étende dans le prolongement de la paroi latérale (13) de la platine-support (12) pour délimiter avec cette dernière un logement ouvert vers l'avant adapté à recevoir un mécanisme d'appareillage électrique (20), **caractérisée en ce que** la paroi latérale (13) de la platine-support (12) comporte, à l'arrière desdits moyens de montage du cadre (17), au moins sur une partie de son pourtour, une paroi double (100) comprenant une paroi interne (110) et une paroi externe (120) reliées entre elles à des endroits ponctuels par des nervures (115).

2. Boîte électrique (10) selon la revendication 1, dans laquelle ladite paroi double (100) s'étend sur tout le pourtour de ladite paroi latérale (13) de la platine-support (12).

3. Boîte électrique (10) selon l'une des revendications 1 et 2, dans laquelle les nervures (115) sont régulièrement réparties le long de ladite paroi double (100).

4. Boîte électrique (10) selon l'une quelconque des revendications 1 à 3, dans laquelle chaque nervure (115) s'étend en largeur perpendiculairement aux faces en regard des parois interne (110) et externe (120) de la paroi double (100).

5. Boîte électrique (10) selon l'une quelconque des revendications 1 à 3, dans laquelle chaque nervure (115) s'étend en largeur suivant une direction formant un premier angle aigu avec la face de la paroi interne (110) tournée vers la paroi externe (120) de la paroi double (100).

6. Boîte électrique (10) selon l'une quelconque des revendications 1 à 3, dans laquelle chaque nervure (115) s'étend en largeur suivant une direction formant un deuxième angle aigu avec la face de la paroi externe (120) tournée vers la paroi interne (110) de la paroi double (100).

7. Boîte électrique (10) selon les revendications 5 et 6, dans laquelle le premier angle et le deuxième angle sont égaux.

8. Boîte électrique (10) selon l'une quelconque des revendications 1 à 7, dans laquelle chaque nervure (115) s'étend en hauteur sur toute la hauteur de ladite paroi double (100).

9. Boîte électrique (10) selon l'une quelconque des revendications 1 à 8, dans laquelle, en outre des nervures (115), les parois interne (110) et externe (120) sont reliées entre elles par un pont (130) qui s'étend entre les parois externe (120) et interne (110) sur tout le pourtour de la paroi double (100).

10. Boîte électrique (10) selon la revendication 9, dans laquelle chaque nervure (115) s'étend en hauteur depuis une région située à proximité d'un bord libre des parois externe et interne jusqu'au pont (130).

11. Boîte électrique (10) selon l'une quelconque des revendications 1 à 10, dans laquelle les moyens de montage du cadre (17) comprennent une gorge (140) ouverte pour la réception d'une extrémité libre (180) d'un bord arrière (18C) dudit cadre (17).

12. Boîte électrique (10) selon l'une quelconque des revendications 1 à 11, dans laquelle il est prévu des moyens de coopération entre la paroi latérale (18) du cadre (17) et la paroi latérale (13) de la platine-support (12) tels que, à la jonction du cadre (17) et de la platine-support (12), la face externe de la paroi latérale (18) du cadre (17) s'étend dans le même plan que la face externe de la paroi latérale (13) de la platine-support (12).

13. Appareillage électrique (1) comprenant une boîte électrique (10) selon l'une quelconque des revendications 1 à 12, un mécanisme d'appareillage électrique (20) reçu dans le logement délimité dans ladite boîte électrique (10) et un enjoliveur (30) fixé à l'avant de ladite boîte électrique (10) et fermant ledit logement.

## Patentansprüche

1. Elektrodose (10) mit einem Körper (15), der einerseits eine Trägerplatine (12), die eine Rückwand (11), die mit Mitteln zum Befestigen an einer Aufnahmewand versehen ist, und eine die Rückwand (11) umgebende Seitenwand (13) aufweist und andererseits einen Rahmen (17), der eine Seitenwand (18), die in Montagemittel der Seitenwand (13) der Trägerplatine (12) so eingesetzt ist, daß sich die Seitenwand (18) des Rahmens (17) in Verlängerung der Seitenwand (13) der Trägerplatine (12) erstreckt, um mit letzterer einen nach vorne offenen Raum abzugrenzen, der geeignet ist, einen elektrischen Gerätemechanismus (20) aufzunehmen, aufweist, **dadurch gekennzeichnet, daß** die Seitenwand (13) der Trägerplatine (12) an der Rückseite der Montagemittel des Rahmens (17) mindestens über einen Teil ihres Umfangs eine doppelte Wand (100) mit einer inneren Wand 110) und einer äußeren Wand (120) aufweist, die stellenweise durch Rippen (115) miteinander verbunden sind.

2. Elektrodose (10) gemäß Anspruch 1, bei der sich die doppelte Wand (100) über den gesamten Umfang der Seitenwand (13) der Trägerplatine (12) erstreckt.

3. Elektrodose (10) gemäß einem der Ansprüche 1 und 2 , bei der die Rippen (115) gleichmäßig entlang der doppelten Wand (100) verteilt sind.

4. Elektrodose (10) gemäß einem der Ansprüche 1 bis 3, bei der sich jede Rippe (115) in der Breite senkrecht zu den einander gegenüberliegenden Seiten der inneren (110) und der äußeren (120) Wand der doppelten Wand (100) erstreckt.

5. Elektrodose (10) gemäß einem der Ansprüche 1 bis 3, bei der sich jede Rippe (115) in der Breite in einer Richtung erstreckt, die mit der zur äußeren Wand (120) der doppelten Wand (100) gerichteten Seite der inneren Wand (110) einen ersten spitzen Winkel bildet.

6. Elektrodose (10) gemäß einem der Ansprüche 1 bis 3, bei der sich jede Rippe (115) in der Breite in einer Richtung erstreckt, die mit der zur inneren Wand (110) der doppelten Wand (100) gerichteten Seite der äußeren Wand (120) einen zweiten spitzen Winkel bildet.

7. Elektrodose (10) gemäß den Ansprüchen 5 und 6, bei der der erste Winkel und der zweite Winkel gleich sind.

8. Elektrodose (10) gemäß einem der Ansprüche 1 bis 7, bei der sich jede Rippe (115) in der Höhe über die gesamte Höhe der doppelten Wand (100) erstreckt.

9. Elektrodose (10) gemäß einem der Ansprüche 1 bis 8, bei der die innere (110) und die äußere (120) Wand, außer durch die Rippen (115), durch eine Brücke (130) miteinander verbunden sind, die sich zwischen der äußeren (120) und der inneren (110) Wand über den gesamten Umfang der doppelten Wand (100) erstreckt.

10. Elektrodose (10) gemäß Anspruch 9, bei der sich jede Rippe (115) in der Höhe von einem Bereich aus erstreckt, der sich in der Nähe eines freien Rands der äußeren und der inneren Wand bis zur Brücke (130) erstreckt.

11. Elektrodose (10) gemäß einem der Ansprüche 1 bis 10, bei der die Montagemittel des Rahmens (17) eine Hohlkehle (140) aufweisen, die zur Aufnahme eines freien Endes (180) eines rückwärtigen Rands (18C) des Rahmens (17) offen ist.

12. Elektrodose (10) gemäß einem der Ansprüche 1 bis 11, bei der Mittel für ein Zusammenwirken zwischen der Seitenwand (18) des Rahmens (17) und der Seitenwand (13) der Trägerplatine (12) so vorgesehen sind, daß sich die Außenseite (18) des Rahmens (17) an der Verbindung des Rahmens (17) mit der Trägerplatine (12) in der gleichen Ebene erstreckt wie die Außenseite der Seitenwand (13) der Trägerplatine (12).

13. Elektrisches Gerät (1) mit einer Elektrodose (10) gemäß einem der Ansprüche 1 bis 12, einem in dem in der Elektrodose (10) abgegrenzten Raum aufgenommenen elektrischen Gerätemechanismus (20) und einer Blende (30), die auf der Vorderseite der Elektrodose (10) befestigt ist und den Raum abschließt.

## Claims

1. Electrical box (10) provided with a body (15) comprising, on the one hand, a support plate (12) comprising a bottom wall (11) provided with means for fastening to a receiving support and a side wall (13) bordering said bottom wall (11), and, on the other hand, a frame (17) comprising a side wall (18) fixed in means for mounting the side wall (13) of said support plate (12) such that the side wall (18) of the frame (17) extends into the extension of the side wall (13) of the support plate (12) to delimit with the latter, a housing open frontward, adapted to receive an electrical equipment mechanism (20), **characterised in that** the side wall (13) of the support plate (12) comprises, to the rear of said means for mounting the frame (17), at least over some of its perimeter, a double wall (100) comprising an internal wall (100) and an external wall (120) connected to one another at specific places by ridges (115).

2. Electrical box (10) according to claim 1, wherein said double wall (100) extends over the whole perimeter of said side wall (13) of the support plate (12).

3. Electrical box (10) according to any one of claims 1 and 2, wherein the ridges (115) are regularly distributed along said double wall (100).

4. Electrical box (10) according to any one of claims 1 to 3, wherein each ridge (115) extends by width perpendicularly to the faces facing the internal (110) and external (120) walls of the double wall (100).

5. Electrical box (10) according to any one of claims 1 to 3, wherein each ridge (115) extends by width in a direction forming a first acute angle with the face of the internal wall (110) facing the external wall (120) of the double wall (100).

6. Electrical box (10) according to any one of claims 1 to 3, wherein each ridge (115) extends by width in a direction forming a second acute angle with the face of the external wall (120) facing the internal wall (110) of the double wall (100).

7. Electrical box (10) according to claims 5 and 6, wherein the first angle and the second angle are equal.

8. Electrical box (10) according to any one of claims 1 to 7, wherein each ridge (115) extends by height over the whole height of said double wall (100).

9. Electrical box (10) according to any one of claims 1 to 8, wherein, further to the ridges (115), the internal (110) and external (120) walls are connected to one another by a bridge (130) which extends between the external (120) and internal (110) walls over the whole perimeter of the double wall (100).

10. Electrical box (10) according to claim 9, wherein each ridge (115) extends by height from a region located in the proximity of a free edge of the external and internal walls to the bridge (130).

11. Electrical box (10) according to any one of claims 1 to 10, wherein the means for mounting the frame (17) comprise a groove (140) open for receiving a free end (180) of a rear edge (18C) of said frame (17).

12. Electrical box (10) according to any one of claims 1 to 11, wherein engagement means are provided between the side wall (18) of the frame (17) and the side wall (13) of the support plate (12) such that, at the junction of the frame (17) and of the support plate (12), the external face of the side wall (18) of the frame (17) extends into the same plane as the external face of the side wall (13) of the support plate (12).

13. Electrical equipment (1) comprising an electrical box (10) according to any one of claims 1 to 12, an electrical equipment mechanism (20) received in the delimited housing in said electrical box (10) and a cap (30) fastened to the front of said electrical box (10) and closing said housing.
